# EUROPEAN PATENT APPLICATION

(11) **EP 4 715 473 A1**
(43) Date of publication of application: **25.03.2026**
(21) Application number: 25201719.9
(22) Date of filing: 11.09.2025
(51) Int. Cl.: G03G 15/00, G03G 21/20, F25D 19/00, G03G 21/16, H05K 7/20

(54) **COOLING DEVICE AND IMAGE FORMING APPARATUS**

(30) Priority: 19.09.2024 JP 2024161634
(71) Applicant: KYOCERA Document Solutions Inc., Osaka-shi, Osaka 540-8585 (JP)
(72) Inventor: Soda, Tomohisa, Osaka-shi, 540-8585 (JP); Ohashi, Hiroaki, Osaka-shi, 540-8585 (JP)
(74) Representative: Plougmann Vingtoft a/s

(57) **Abstract**

A cooling device (6) includes a tank (61), a main tray (601), a pump (62), a heat exchanging portion (6b), a radiator (63), and a plurality of tubes (6c). The pump (62) and the radiator (63) are disposed on the main tray (601). The tank (61) includes an upper surface tray (61b), a tube fixing portion (61d), and a liquid discharging portion (61e). The upper surface tray (61b) forms an upper surface of the tank (61). The tube fixing portion (61d) fixes a portion of a pair of specific tubes (6ca) to the upper surface tray (61b) with the pair of specific tubes (6ca) penetrating the upper surface tray (61b). The liquid discharging portion (61e) forms a discharge path of liquid from the upper surface tray (61b) to the main tray (601).

## Description

### INCORPORATION BY REFERENCE

This application is based upon and claims the benefit of priority from the corresponding Japanese Patent Application No. 2024-161634 filed on September 19, 2024, the entire contents of which are incorporated herein by reference.

### BACKGROUND

This disclosure relates to a cooling device and an image forming apparatus. The cooling device includes a tank that stores liquid refrigerant.

A device that composes an image forming apparatus tends to be high in temperature because of a print process increased in speed.

For example, toner stored in a developing device is high in temperature in an electrophotographic image forming apparatus in some cases because of frictional heat generated by the toner being stirred. When the temperature of the toner increases, the softened toner may agglomerate to result in decreased image quality.

Accordingly, the image forming apparatus includes a cooling device in some cases. For example, it has been known that the electrophotographic image forming apparatus includes a liquid-cooling device which cools the developing device.

### SUMMARY

A cooling device according to an aspect of this disclosure includes a tank, a main tray, a pump, a heat exchanging portion, a radiator, and a plurality of tubes. The tank stores liquid refrigerant. The main tray is disposed adjacent to the tank and capable of receiving liquid. The pump is disposed on the main tray and circulates the liquid refrigerant. The heat exchanging portion exchanges heat between the liquid refrigerant and a cooling target. The radiator is disposed on the main tray and radiates heat of the liquid refrigerant. The plurality of tubes connects the tank, the pump, the heat exchanging portion, and the radiator to form a circulation path of the liquid refrigerant. The tank includes an upper surface tray, a tube fixing portion, and a liquid discharging portion. The upper surface tray forms an upper surface of the tank at a position higher than the main tray and is capable of receiving of liquid. The tube fixing portion fixes a portion of a pair of specific tubes of the plurality of tubes to the upper surface tray with the pair of specific tubes penetrating the upper surface tray. The pair of specific tubes composes an inflow path of the liquid refrigerant to the tank and an outflow path of the liquid refrigerant from the tank. The liquid discharging portion is formed at an edge of the upper surface tray and forms a discharge path of liquid from the upper surface tray to the main tray.

An image forming apparatus according to another aspect of this disclosure includes a printing device configured to form an image on a sheet, and the cooling device configured to cool a portion of the printing device.

This Summary is provided to introduce a selection of concepts in a simplified form that are further described below in the Detailed Description with reference where appropriate to the accompanying drawings. This Summary is not intended to identify key features or essential features of the claimed subject matter, nor is it intended to be used to limit the scope of the claimed subject matter. Furthermore, the claimed subject matter is not limited to implementations that solve any or all disadvantages noted in any part of this disclosure.

### BRIEF DESCRIPTION OF THE DRAWINGS

FIG. 1 is a configuration diagram of an image forming apparatus including a cooling device according to an embodiment.
FIG. 2 is a block diagram showing a configuration of a control device in the image forming apparatus including the cooling device according to the embodiment.
FIG. 3 is a perspective view of a main cooling unit in the cooling device according to the embodiment.
FIG. 4 is a plan view of the main cooling unit in a normal state in the cooling device according to the embodiment.
FIG. 5 is a plan view of the main cooling unit in a state in which the main cooling unit is drawn out in the cooling device according to the embodiment.
FIG. 6 is a first perspective view of a tank state detector with a tank of the cooling device according to the embodiment present at an attachment position.
FIG. 7 is a second perspective view of the tank state detector with the tank of the cooling device according to the embodiment present at the attachment position.
FIG. 8 is a perspective view of the tank state detector with the tank of the cooling device according to the embodiment apart from the attachment position.
FIG. 9 is a perspective view of a liquid leak detector in the cooling device according to the embodiment.

### DETAILED DESCRIPTION

Hereinafter, an embodiment of this disclosure will be described with reference to the drawings. It is noted that the following embodiment is a specific example of this disclosure and does not limit the technical scope of this disclosure.

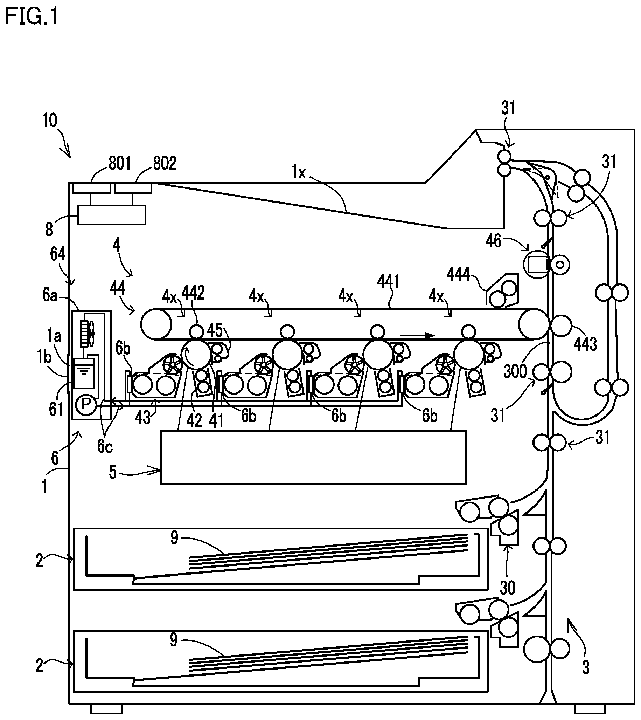

A cooling device 6 according to the embodiment composes a portion of an image forming apparatus 10 (see FIG. 1).

### [Configuration of Image Forming Apparatus 10]

As shown in FIG. 1, the image forming apparatus 10 includes a sheet conveying device 3, a printing device 4, and the cooling device 6. Furthermore, the image forming apparatus 10 includes a body 1 that is a housing in which the sheet conveying device 3, the printing device 4, and the cooling device 6 are stored.

The sheet conveying device 3 conveys a sheet 9. The sheet conveying device 3 includes a sheet feeding mechanism 30 and a plurality of conveying roller pairs 31. The sheet feeding mechanism 30 feeds the sheet 9 stored in a sheet storing portion 2 to a conveyance path 300. The conveyance path 300 is a path along which the sheet 9 is conveyed.

The plurality of conveying roller pairs 31 is each rotationally driven by an unillustrated motor. The plurality of conveying roller pairs 31 conveys the sheet 9 along the conveyance path 300 and further discharges the sheet 9 to a discharge tray 1x by rotating.

The printing device 4 executes a print process. The print process is a process of forming an image on the sheet 9 conveyed by the sheet conveying device 3. The sheet 9 is an image forming medium such as a paper sheet or a sheet-shaped resin member.

In this embodiment, the printing device 4 executes the print process by electrophotography. The printing device 4 includes one or more image forming portions 4x, a laser scanning unit 5, a transfer device 44, and a fixing device 46.

In the example shown in FIG. 1, the image forming apparatus 10 is a tandem-type color-image forming apparatus. The printing device 4 therefore includes the plurality of image forming portions 4x corresponding to a plurality of toner colors.

Each of the image forming portions 4x includes a drum-shaped photoconductor 41, a charging device 42, a developing device 43, a drum cleaning device 45, and the like. That is, the printing device 4 includes the plurality of photoconductors 41, the plurality of developing devices 43, and the plurality of drum cleaning devices 45 corresponding to the plurality of toner colors.

In each of the image forming portions 4x, the photoconductor 41 rotates and the charging device 42 charges a surface of the photoconductor 41. The laser scanning unit 5 scans the respective charged surfaces of the plurality of photoconductors 41 with a plurality of respective pieces of laser light. This forms electrostatic latent images on the respective surfaces of the photoconductors 41.

The respective developing devices 43 supply toners to the respective surfaces of the photoconductors 41 to develop the electrostatic latent images into toner images. Each of the toners is a granular developer. Each of the photoconductors 41 is an example of an image-carrying member that rotates while carrying the toner image.

In this embodiment, the printing device 4 includes the four image forming portions 4x corresponding to the toners for the four developed colors of yellow, cyan, magenta, and black. The printing device 4 thus includes the four photoconductors 41, the four developing devices 43, and the four drum cleaning devices 45.

The four toner images are formed on the surfaces of the four photoconductors 41. The transfer device 44 transfers the four toner images to the sheet 9 from the four photoconductors 41.

The transfer device 44 includes an intermediate transfer belt 441, four primary transfer devices 442 corresponding to the four image forming portions 4x, a secondary transfer device 443, and a belt cleaning device 444.

The four primary transfer devices 442 transfer the toner images on the surfaces of the four photoconductors 41 to a surface of the intermediate transfer belt 441. This forms, on the surface of the intermediate transfer belt 441, a color toner image in which the toner images on the four photoconductors 41 are combined.

The secondary transfer device 443 transfers the color toner image formed on the intermediate transfer belt 441 to the sheet 9 at a transfer position in the conveyance path 300.

The fixing device 46 applies pressure to the color toner image transferred to the sheet 9 while heating the color toner image. The fixing device 46 hereby fixes the color toner image onto the sheet 9.

The drum cleaning devices 45 remove the waste toners remaining on the respective surfaces of the photoconductors 41. The belt cleaning device 444 removes the waste toner remaining on the intermediate transfer belt 441.

The image forming apparatus 10 further includes an operation device 801, a display device 802, and a control device 8.

The operation device 801 is a device that receives a human operation. For example, the operation device 801 includes one or both of a touch panel and an operation button.

The display device 802 is capable of displaying various kinds of information. For example, the display device 802 is a panel display device such as a liquid-crystal display device. The control device 8 controls various electrical devices included in the image forming apparatus 10.

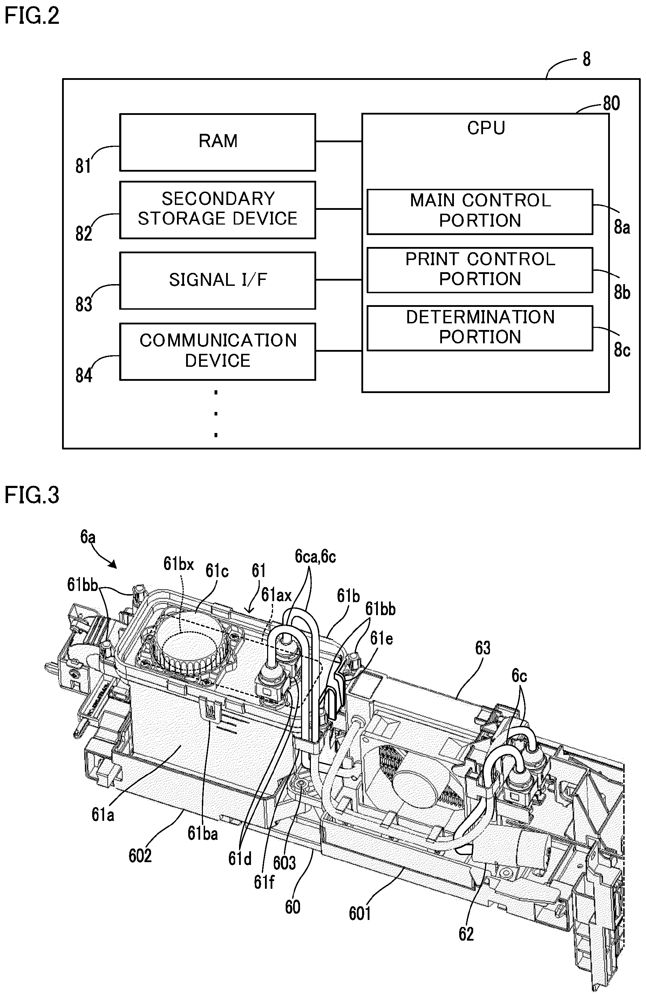

As shown in FIG. 2, the control device 8 includes a central processing unit (CPU) 80, a random access memory (RAM) 81, a secondary storage device 82, a signal interface 83, a communication device 84, and the like.

The CPU 80 executes various kinds of control and data processing by executing a computer program. The RAM 81 is a volatile storage device. The RAM 81 temporarily stores the computer program executed by the CPU 80 and various kinds of data.

The secondary storage device 82 is a computer-readable non-volatile storage device. The secondary storage device 82 stores the computer program executed by the CPU 80 and the various kinds of data. For example, one of a flash memory or a hard disk drive or both of the flash memory and the hard disk drive are adopted as the secondary storage device 82.

The signal interface 83 converts sense signals of various sensors into digital sense data. The sense data is transmitted to the CPU 80.

The communication device 84 executes communication with a plurality of external apparatuses including one or more host apparatuses through a network. The CPU 80 executes communication with each of the external apparatuses through the communication device 84. The host apparatus is an information processing apparatus that requests the image forming apparatus 10 to execute the print process.

The CPU 80 includes a plurality of processing modules implemented by executing the computer program. The plurality of processing modules includes a main control portion 8a, a print control portion 8b, a determination portion 8c, and the like (see FIG. 2).

The main control portion 8a executes a process of receiving various requests and control of causing another module to execute a process corresponding to a request. For example, the main control portion 8a receives a print request through the operation device 801 or the communication device 84. Furthermore, the main control portion 8a causes the print control portion 8b to execute a process corresponding to the print request.

The print control portion 8b controls the sheet conveying device 3 and the printing device 4. The print control portion 8b causes the printing device 4 to execute the print process while causing the sheet conveying device 3 to convey the sheet 9.

The determination portion 8c determines the various states of the image forming apparatus 10 depending on the sensing states of the various sensors and the operation states of various devices in the image forming apparatus 10.

The cooling device 6 cools a portion of the printing device 4. The cooling device 6 includes a main cooling unit 6a, one or more heat exchanging portions 6b disposed at the positions of cooling targets, and a plurality of tubes 6c (see FIGS. 1 and 3).

The heat exchanging portion 6b exchanges heat between the cooling target and liquid refrigerant. The heat exchanging portion 6b hereby cools the cooling target higher in temperature than the liquid refrigerant.

The cooling target is a portion of the printing device 4. In this embodiment, the cooling target is the developing device 43 (see FIG. 1).

In this embodiment, the cooling device 6 includes the four heat exchanging portions 6b and the cooling targets are the four developing devices 43. That is, the cooling device 6 cools the respective developing devices 43. The cooling device 6 reduces the rise in the temperature of toner caused by frictional heat generated by the toner being stirred in each of the developing devices 43.

The main cooling unit 6a includes a support base 60, a main tray 601, a tank support 602, a tank 61, a pump 62, and a radiator 63 (see FIG. 3).

Incidentally, the pump 62 circulates liquid refrigerant to the tank 61, the heat exchanging portions 6b, and the radiator 63 in the liquid-cooling device 6. The tank 61, the pump 62, the heat exchanging portions 6b, and the radiator 63 are connected by the plurality of tubes 6c.

The plurality of tubes 6c connects the tank 61, the pump 62, the heat exchanging portions 6b, and the radiator 63 to form a circulation path of the liquid refrigerant.

The liquid refrigerant vaporizes and slightly leaks from connection portions between devices. The long-term use of the cooling device 6 therefore gradually decreases the liquid refrigerant in the tank 61.

In a case where the level of the liquid refrigerant in the tank 61 falls below a permissible range, it is necessary to refill the tank 61 with the liquid refrigerant or replace the tank 61.

Meanwhile, the liquid refrigerant leaks at portions of the plurality of tubes 6c connected to the devices in some cases. Since the tank 61 is operated to be refilled with the liquid refrigerant or to be replaced with the tank 61, the liquid refrigerant is likely to leak in particular at the portions of the plurality of tubes 6c connected to the tank 61.

It is unpreferable that the leaked liquid refrigerant flow out of the cooling device 6. The cooling device 6 therefore includes a component that prevents the leaked liquid refrigerant from the portions of the plurality of tubes 6c connected to the devices from flowing to the outside.

In this embodiment, in a case where the level of the liquid refrigerant in the tank 61 falls below the permissible range, it is necessary to refill the tank 61 with the liquid refrigerant. It is desirable to allow the tank 61 to be easily refilled with the liquid refrigerant in the cooling device 6.

The cooling device 6 also includes a component that facilitates the tank 61 to be refilled with the liquid refrigerant.

### [Configuration of Main Cooling Unit 6a]

As described above, the main cooling unit 6a includes the support base 60, the main tray 601, the tank support 602, the tank 61, the pump 62, and the radiator 63 (see FIG. 3).

The tank 61 stores the liquid refrigerant. The tank 61 includes a cap 61c that closes a supply port 61bx having communication with inside of the tank 61 (see FIG. 3). The cap 61c allows the supply port 61bx to be opened and closed. The supply port 61bx is formed on the upper surface of the tank 61. In this embodiment, the cap 61c is a screw cap.

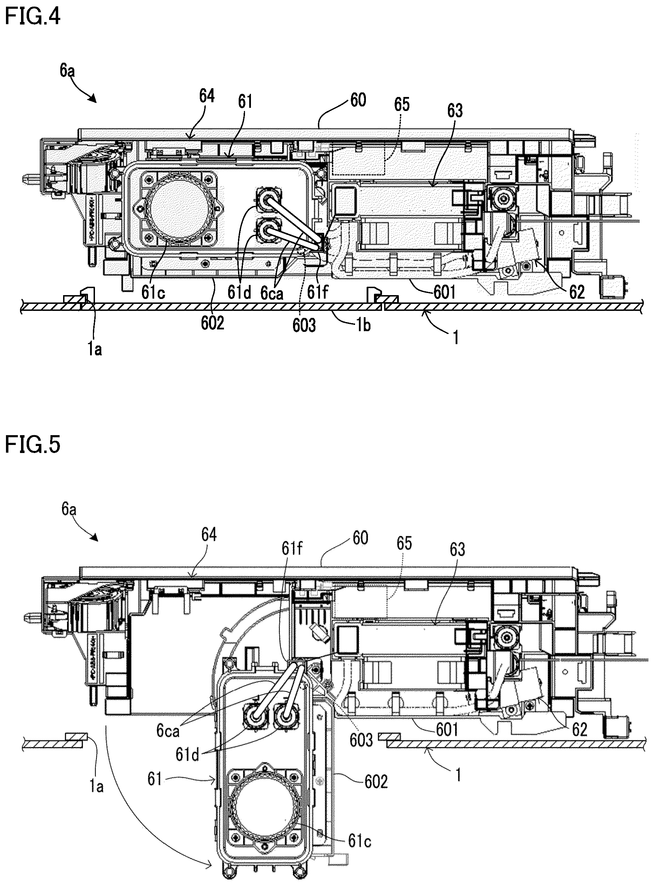

The body 1 includes an access opening 1a formed at a position opposed to the tank 61 and a cover 1b that allows the access opening 1a to be opened and closed (see FIGS. 1 and 4). FIG. 5 shows a state in which the cover 1b is detached from a position at which the cover 1b closes the access opening 1a on the body 1.

The support base 60 supports the main tray 601 and the tank support 602. The main tray 601 is disposed adjacent to the tank 61. The pump 62 and the radiator 63 are disposed on the main tray 601. The tank support 602 supports the tank 61.

The outer edge portion of the main tray 601 is an annular projecting portion that projects upward from the inner portion of the outer edge portion. This allows the main tray 601 to receive liquid on the inner portion of the outer edge portion.

In a case where the liquid refrigerant leaks from the pump 62 or the radiator 63, the leaked liquid refrigerant accumulates in the main tray 601. In a case where the liquid refrigerant leaks from portions of the plurality of tubes 6c connected to the pump 62 or the radiator 63, the leaked liquid refrigerant also accumulates in the main tray 601 similarly.

The radiator 63 radiates the heat of the liquid refrigerant increased in temperature by heat exchange with the four developing devices 43. In the example shown in FIG. 3, the radiator 63 is an air-cooling device including a cooling fan.

The tank support 602 supports the tank 61 and is supported so as to be pivotable about a shaft portion 603 disposed along the perpendicular direction. The shaft portion 603 is disposed in a unit region that is a region occupied by the support base 60 (see FIGS. 3 to 5).

The unit region is a region in the body 1 and includes the region in which the main tray 601 is disposed. That is, the unit region includes the regions in which the pump and the radiator are disposed. In this embodiment, the shaft portion 603 is disposed in the region along the outer edge of the main tray 601 (see FIGS. 3 to 5).

The tank support 602 pivots to move the tank 61 between an actuation position and a supply position. The tank 61 is contained within the unit region at the actuation position. The cap 61c sticks out of the unit region at the supply position.

When the cover 1b is open, the tank support 602 is drawn out of the body 1 to pivot to a position at which the tank support 602 sticks out of the body 1 from the inside of the body 1 (see FIGS. 4 and 5). This moves the tank 61 from the actuation position to the supply position.

FIGS. 3 and 4 each show the main cooling unit 6a with the tank 61 present at the actuation position and FIG. 5 shows the main cooling unit 6a with the tank 61 present at the supply position.

When the tank 61 moves from the actuation position to the supply position, the cap 61c of the tank 61 moves out of the body 1 from the inside of the body 1 through the access opening 1a (see FIGS. 4 and 5).

That is, when the tank 61 is present at the actuation position, the cap 61c is present in the body 1. When the tank 61 is present at the supply position, the cap 61c is exposed to the outside of the body 1. When the tank 61 is present at the supply position, it is possible to easily detach the cap 61c and refill the tank 61 with the liquid refrigerant.

The plurality of tubes 6c includes a pair of specific tubes 6ca that composes an inflow path of the liquid refrigerant to the tank 61 and an outflow path of the liquid refrigerant from the tank 61 (see FIGS. 4 and 5).

The tank 61 includes a tube fixing portion 61d and a tube holding portion 61f (see FIGS. 3 to 5).

The tube fixing portion 61d is a portion that fixes a portion of the pair of specific tubes 6ca to the upper surface of the tank 61 with the pair of specific tubes 6ca penetrating the upper surface of the tank 61. The tube fixing portion 61d is a portion that connects the pair of specific tubes 6ca to the tank 61.

In this embodiment, the tube fixing portion 61d is composed of a pair of members or a pair of units that individually fixes the pair of respective specific tubes 6ca to the upper surface of the tank 61. It is noted that the tube fixing portion 61d may be composed of one member or one unit.

The tube fixing portion 61d is disposed at a position closer to the shaft portion 603 than the cap 61c. In this embodiment, the tank 61 has an outer shape having, as the longitudinal direction, the direction in which the cap 61c and the tube fixing portion 61d are arranged in a plan view.

The tube holding portion 61f is provided on a side surface of the tank 61 (see FIG. 3). The tube holding portion 61f holds a portion of the pair of specific tubes 6ca along an extension line of the shaft portion 603 (see FIG. 3 to 5).

The tube holding portion 61f prevents the pair of specific tubes 6ca from having high tension when the tank 61 pivots along with the tank support 602.

The tank 61 further includes an upper surface tray 61b and a liquid discharging portion 61e (see FIG. 3). The upper surface tray 61b forms the upper surface of the tank 61 at a position higher than the main tray 601.

The supply port 61bx is formed on the upper surface tray 61b. The cap 61c is detachably attached to the upper surface tray 61b. The cap 61c closes the supply port 61bx by being attached to the upper surface tray 61b.

The outer edge portion of the upper surface tray 61b is an annular projecting portion that projects upward from the inner portion of the outer edge portion. This allows the upper surface tray 61b to receive liquid on the inner portion of the outer edge portion.

The upper surface tray 61b is capable of storing less liquid than that of the main tray 601. In other words, the main tray 601 is capable of storing more liquid than that of the upper surface tray 61b.

The tube fixing portion 61d fixes a portion of the pair of specific tubes 6ca to the upper surface tray 61b with the pair of specific tubes 6ca penetrating the upper surface tray 61b (see FIG. 3).

The liquid discharging portion 61e is formed at the edge of the upper surface tray 61b and forms a discharge path of liquid from the upper surface tray 61b to the main tray 601.

In a case where the liquid refrigerant leaks from the tube fixing portion 61d, the leaked liquid refrigerant temporarily accumulates in the upper surface tray 61b and then flows to the main tray 601 through the liquid discharging portion 61e.

In the main cooling unit 6a, the size of the tank 61 is larger than the size of the pump 62 and the size of the radiator 63. In a case where the larger main tray 601 is adopted and the tank 61 is disposed on the main tray 601, the main cooling unit 6a has a larger height dimension.

In contrast, the upper surface tray 61b is lower in height than the tube fixing portion 61d and a portion of the pair of specific tubes 6ca extending from the tube fixing portion 61d. The upper surface tray 61b thus has no influence on the height dimension of the tank 61.

In addition, the tank 61 is disposed from a position lower than the main tray 601 to a position higher than the main tray 601 (see FIG. 3). This efficiently disposes the tank 61, the pump 62, and the radiator 63 and makes it possible to implement the main cooling unit 6a having a smaller height dimension.

In this embodiment, the tank 61 includes a tank body 61a and the upper surface tray 61b (see FIG. 3). The tank body 61a stores the liquid refrigerant and has a body opening 61ax that opens upward (see FIG. 3).

The upper surface tray 61b is detachably attached to the tank body 61a. The upper surface tray 61b closes the body opening 61ax by being attached to the tank body 61a.

In this embodiment, the upper surface tray 61b is fixed to the tank body 61a by a snap-fit 61ba and a plurality of screws 61bb (see FIG. 3).

The main cooling unit 6a further includes a tank state detector 64 and a liquid leak detector 65 (see FIGS. 4 to 9).

The tank state detector 64 detects a normal state of the tank 61 and an abnormal state of the tank 61. The normal state is a state in which the level of the liquid refrigerant in the tank 61 is within a permissible range in a situation in which the tank 61 is present at the actuation position. The abnormal state includes a first abnormal state or a second abnormal state.

The first abnormal state is a state in which the level of the liquid refrigerant in the tank 61 falls below the permissible range in a situation in which the tank 61 is present at the actuation position. The second abnormal state is a state in which the tank 61 is not present at the actuation position.

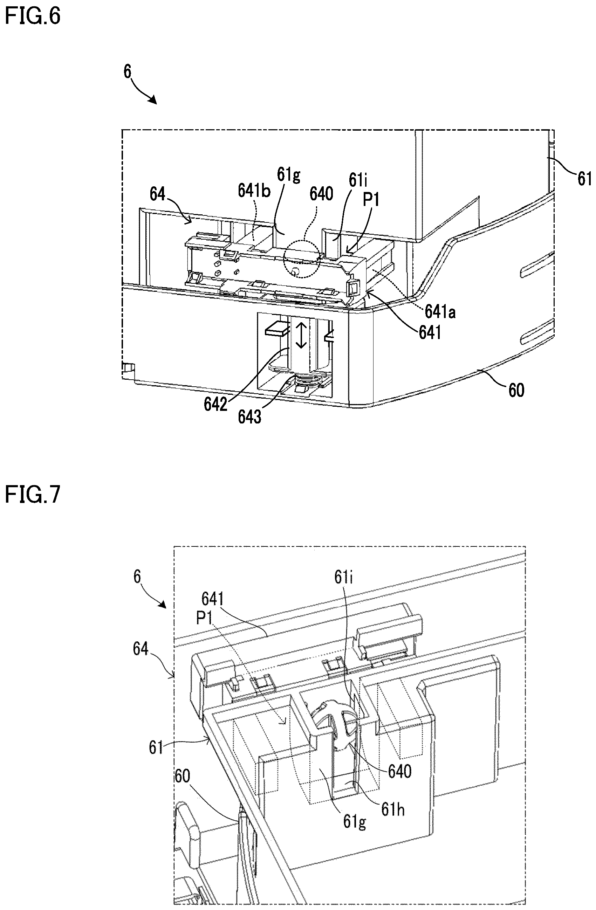

In this embodiment, the tank state detector 64 includes a first floating body 640, a lower limit restricting portion 61h, a movable member 642, a biasing member 643, and a first object sensor 641 (see FIGS. 6 and 7).

The first object sensor 641 senses an object present at a first sensing position P1 above the support base 60. As described below, in a case where the movable member 642 or the first floating body 640 is present at the first sensing position P1, the first object sensor 641 senses the movable member 642 or the first floating body 640.

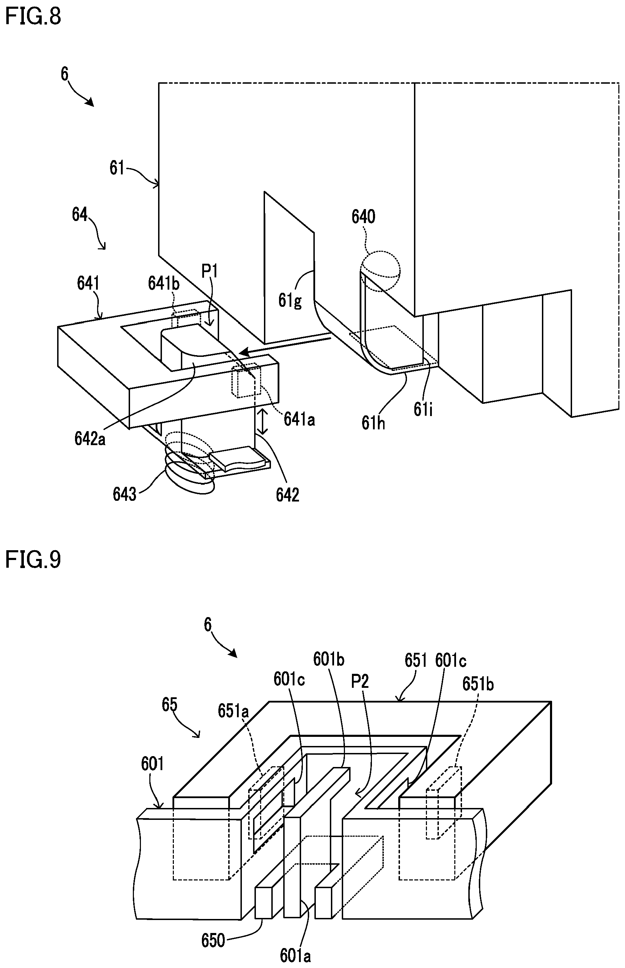

For example, the first object sensor 641 is a transmissive photosensor including a light emitting portion 641a and a light receiving portion 641b (see FIGS. 6 and 8). The first sensing position P1 is a position between the light emitting portion 641a and the light receiving portion 641b.

The first floating body 640 is an object that is stored in the tank 61 along with the liquid refrigerant and is smaller in density than the liquid refrigerant. The first floating body 640 floats on the liquid refrigerant in the tank 61. The position of the first floating body 640 thus changes up and down depending on the liquid level of the liquid refrigerant in the tank 61.

The lower limit restricting portion 61h is provided in the tank 61 and restricts the range within which the first floating body 640 is movable in the up-down direction to a range having a lower limit position defined in advance as a lower limit. The lower limit position in a situation in which the tank 61 is present at the actuation position is the first sensing position P1 (see FIG. 7).

In this embodiment, the tank 61 further includes a floating body guiding portion 61g that restricts the movement range of the first floating body 640 in the horizontal direction and guides the first floating body 640 in the up-down direction (see FIGS. 6 and 7).

The movable member 642 is supported so as to be movable between a reference position and a retraction position. FIG. 6 shows a situation in which the movable member 642 is present at the retraction position and FIG. 8 shows a situation in which the movable member 642 is present at the reference position. The movable member 642 includes a detection target portion 642a that is moved to the first sensing position P1 by the movable member 642 moving to the reference position and is moved apart from the first sensing position P1 by the movable member 642 moving to the retraction position (see FIG. 8).

In this embodiment, the movable member 642 is supported so as to be movable in the up-down direction and the detection target portion 642a is the upper end of the movable member 642.

The biasing member 643 biases the movable member 642 toward the reference position. The biasing member 643 holds the movable member 642 at the reference position when the tank 61 is present at the supply position (see FIG. 8).

In this embodiment, the biasing member 643 is a spring that biases the movable member 642 upward (see FIGS. 6 and 8).

The movable member 642 is held at the retraction position by coming into contact with the tank 61 present at the actuation position (see FIG. 6). That is, the tank 61 holds the movable member 642 at the retraction position against the biasing force of the biasing member 643 when the tank 61 is present at the actuation position.

In this embodiment, the lower limit restricting portion 61h of the tank 61 comes into contact with the movable member 642. In addition, the tank 61 includes a transparent window 61i that transmits light traveling from the light emitting portion 641a to the light receiving portion 641b through the first sensing position P1 (see FIGS. 6 to 8).

When the tank 61 is present at a position closer to the supply position than the actuation position, the movable member 642 is held at the reference position by the biasing member 643 and the first object sensor 641 senses the detection target portion 642a present at the first sensing position P1 (see FIG. 8).

In contrast, when the liquid level of the liquid refrigerant in the tank 61 falls below the permissible range in a situation in which the tank 61 is present at the actuation position, the first object sensor 641 senses the first floating body 640 present at the first sensing position P1.

That is, the first object sensor 641 senses the detection target portion 642a or the first floating body 640 at the first sensing position P1. A state in which the first object sensor 641 senses the detection target portion 642a is the first abnormal state. A state in which the first object sensor 641 senses the first floating body 640 is the second abnormal state.

When the abnormal state of the tank 61 is detected by the tank state detector 64, the determination portion 8c of the control device 8 notifies an output destination such as another device communicable through the display device 802 or the communication device 84 of a tank abnormality.

In addition, the print control portion 8b of the control device 8 prohibits the pump 62 from being actuated and prohibits the print process from being executed when the abnormal state of the tank 61 is detected by the tank state detector 64.

The liquid leak detector 65 detects liquid accumulated in the main tray 601. That is, the liquid leak detector 65 detects the liquid refrigerant accumulated in the main tray 601.

The liquid leak detector 65 includes a second floating body 650 and a second object sensor 651 (see FIG. 9).

The second object sensor 651 senses an object present at a second sensing position P2 in the main tray 601. Specifically, in a case where the second floating body 650 is present at the second sensing position P2, the second object sensor 651 senses the second floating body 650.

For example, the second object sensor 651 is a transmissive photosensor including a light emitting portion 651a and a light receiving portion 651b (see FIG. 9). The second sensing position P2 is a position between the light emitting portion 651a and the light receiving portion 651b.

The second floating body 650 is an object that is disposed in the main tray 601 and is smaller in density than the liquid refrigerant. The second floating body 650 floats on the liquid refrigerant in the main tray 601. The position of the second floating body 650 thus changes up and down depending on the liquid level of the liquid refrigerant in the main tray 601.

In this embodiment, the main tray 601 includes a floating body guiding portion 601a and an upper limit restricting portion 601b (see FIG. 9). The floating body guiding portion 601a restricts the movement range of the second floating body 650 in the horizontal direction and guides the second floating body 650 in the up-down direction (see FIG. 9). The upper limit restricting portion 601b restricts the movement range of the second floating body 650 in the up-down direction to a range having the second sensing position P2 as an upper limit.

Furthermore, the main tray 601 includes a transparent window 601c that transmits light traveling from the light emitting portion 651a to the light receiving portion 651b through the second sensing position P2 (see FIG. 9).

When the second floating body 650 reaches the second sensing position P2 because of the increased liquid level of the liquid refrigerant in the main tray 601, the second object sensor 651 senses the second floating body 650 present at the second sensing position P2.

A state in which the second object sensor 651 senses the second floating body 650 is a state in which the liquid refrigerant is accumulated in the main tray 601 beyond a permissible range.

When the leaked liquid refrigerant is detected by the liquid leak detector 65, the determination portion 8c of the control device 8 notifies an output destination such as another device communicable through the display device 802 or the communication device 84 of a liquid leak abnormality.

In addition, the print control portion 8b of the control device 8 prohibits the pump 62 from being actuated and prohibits the print process from being executed when the leaked liquid refrigerant is detected by the liquid leak detector 65.

### [First Modification]

In the cooling device 6, one or both of the first object sensor 641 and the second object sensor 651 may be magnetic sensors. In this case, the detection target portion 642a, the first floating body 640, or the second floating body 650 sensed by the magnetic sensors includes a magnetic substance. In addition, ultrasonic sensors may be adopted as one or both of the first object sensor 641 and the second object sensor 651.

### [Second Modification]

The cooling target of the cooling device 6 may be a device other than the developing device 43 in the image forming apparatus 10. For example, the cooling device 6 may cool the fixing device 46.

### [Third Modification]

The cooling device 6 may be applied to an inkjet image forming apparatus. For example, the cooling device 6 may cool an inkjet head.

### [Supplementary Notes of Invention]

The gist of the invention extracted from the embodiment described above will be supplementarily noted below. It is noted that the respective configurations and the respective processing functions described in the following supplementary notes can be sorted out and used in any combination.

### <Supplementary Note 1>

A cooling device including:
a tank configured to store liquid refrigerant;
a main tray disposed adjacent to the tank and capable of receiving liquid;
a pump disposed on the main tray and configured to circulate the liquid refrigerant;
a heat exchanging portion configured to exchange heat between the liquid refrigerant and a cooling target;
a radiator disposed on the main tray and configured to radiate heat of the liquid refrigerant; and
a plurality of tubes configured to connect the tank, the pump, the heat exchanging portion, and the radiator to form a circulation path of the liquid refrigerant, in which
the tank includes
   an upper surface tray configured to form an upper surface of the tank at a position higher than the main tray, the upper surface tray being capable of receiving liquid,
   a tube fixing portion configured to fix a portion of a pair of specific tubes of the plurality of tubes to the upper surface tray with the pair of specific tubes penetrating the upper surface tray, the pair of specific tubes composing an inflow path of the liquid refrigerant to the tank and an outflow path of the liquid refrigerant from the tank, and
   a liquid discharging portion configured to form a discharge path of liquid from the upper surface tray to the main tray, the liquid discharging portion being formed at an edge of the upper surface tray.

### <Supplementary Note 2>

The cooling device according to Supplementary Note 1, including a liquid leak detector configured to detect liquid accumulated in the main tray.

### <Supplementary Note 3>

The cooling device according to Supplementary Note 1 or 2, in which the tank is disposed from a position lower than the main tray to the position higher than the main tray.

### <Supplementary Note 4>

The cooling device according to any one of Supplementary Notes 1 to 3, including a tank support configured to support the tank and be supported so as to be pivotable about a shaft portion disposed in a unit region along a perpendicular direction, the unit region including regions in which the pump and the radiator are disposed.

### <Supplementary Note 5>

The cooling device according to Supplementary Note 4, in which
the tank includes a cap configured to be detachably attached to the upper surface tray and close a supply port formed on the upper surface tray, and
the tank support pivots to move the tank between an actuation position and a supply position, the tank being contained within the unit region at the actuation position, the cap sticking out of the unit region at the supply position.

### <Supplementary Note 6>

The cooling device according to any one of Supplementary Notes 1 to 5, in which
the tank includes a tank body configured to store the liquid refrigerant, the tank body having an upward opening, and
the upper surface tray is detachably attached to the tank body and closes the opening of the tank body.

### <Supplementary Note 7>

An image forming apparatus including:
a printing device configured to form an image on a sheet; and
the cooling device according to any one of Supplementary Notes 1 to 6, the cooling device being configured to cool a portion of the printing device.

### <Supplementary Note 8>

The image forming apparatus according to Supplementary Note 7, in which
the printing device includes
   a photoconductor on a surface of which an electrostatic latent image is formed,
   a developing device configured to develop the electrostatic latent image into a toner image by supplying toner to the surface of the photoconductor, and
   a transfer device configured to transfer the toner image to a sheet from the surface of the photoconductor, and
the cooling device cools the developing device.

It is to be understood that the embodiments herein are illustrative and not restrictive, since the scope of the disclosure is defined by the appended claims rather than by the description preceding them, and all changes that fall within metes and bounds of the claims, or equivalence of such metes and bounds thereof are therefore intended to be embraced by the claims.

## Claims

1. A cooling device (6) comprising:
a tank (61) configured to store liquid refrigerant;
a main tray (601) disposed adjacent to the tank (61) and capable of receiving liquid;
a pump (62) disposed on the main tray (601) and configured to circulate the liquid refrigerant;
a heat exchanging portion (6b) configured to exchange heat between the liquid refrigerant and a cooling target;
a radiator (63) disposed on the main tray (601) and configured to radiate heat of the liquid refrigerant; and
a plurality of tubes (6c) configured to connect the tank (61), the pump (62), the heat exchanging portion (6b), and the radiator (63) to form a circulation path of the liquid refrigerant, wherein
the tank (61) includes
an upper surface tray (61b) configured to form an upper surface of the tank (61) at a position higher than the main tray (601), the upper surface tray (61b) being capable of receiving liquid,
a tube fixing portion (61d) configured to fix a portion of a pair of specific tubes (6ca) of the plurality of tubes (6c) to the upper surface tray (61b) with the pair of specific tubes (6ca) penetrating the upper surface tray (61b), the pair of specific tubes (6ca) composing an inflow path of the liquid refrigerant to the tank (61) and an outflow path of the liquid refrigerant from the tank (61), and
a liquid discharging portion (61e) configured to form a discharge path of liquid from the upper surface tray (61b) to the main tray (601), the liquid discharging portion (61e) being formed at an edge of the upper surface tray (61b).

2. The cooling device (6) according to claim 1, comprising a liquid leak detector (65) configured to detect liquid accumulated in the main tray (601).

3. The cooling device (6) according to claim 1 or 2, wherein the tank (61) is disposed from a position lower than the main tray (601) to the position higher than the main tray (601).

4. The cooling device (6) according to claim 1 or 2, comprising a tank support (602) configured to support the tank (61) and be supported so as to be pivotable about a shaft portion (603) disposed in a unit region along a perpendicular direction, the unit region including regions in which the pump (62) and the radiator (63) are disposed.

5. The cooling device (6) according to claim 4, wherein
the tank (61) includes a cap (61c) configured to be detachably attached to the upper surface tray (61b) and close a supply port formed on the upper surface tray (61b), and
the tank support (602) pivots to move the tank (61) between an actuation position and a supply position, the tank (61) being contained within the unit region at the actuation position, the cap (61c) sticking out of the unit region at the supply position.

6. The cooling device (6) according to claim 1 or 2, wherein
the tank (61) includes a tank body (61a) configured to store the liquid refrigerant, the tank body (61a) having an upward opening, and
the upper surface tray (61b) is detachably attached to the tank body (61a) and closes the opening of the tank body (61a).

7. An image forming apparatus (10) comprising:
a printing device (4) configured to form an image on a sheet; and
the cooling device (6) according to claim 1 or 2, the cooling device (6) being configured to cool a portion of the printing device (4).

8. The image forming apparatus (10) according to claim 7, wherein
the printing device (4) includes
a photoconductor (41) on a surface of which an electrostatic latent image is formed,
a developing device (43) configured to develop the electrostatic latent image into a toner image by supplying toner to the surface of the photoconductor (41), and
a transfer device (44) configured to transfer the toner image to a sheet from the surface of the photoconductor (41), and
the cooling device (6) cools the developing device (43).
